# EUROPEAN PATENT APPLICATION

(11) **EP 4 310 899 A1**
(43) Date of publication of application: **24.01.2024**
(21) Application number: 22186578.5
(22) Date of filing: 22.07.2022
(51) Int. Cl.: H01L 21/768, H01L 23/485, H01L 29/778, H01L 29/40

(54) **GROUP III NITRIDE-BASED SEMICONDUCTOR DEVICE**

(71) Applicant: Infineon Technologies AG, 85579 Neubiberg (DE)
(72) Inventor: BIRNER, Albert, 93051 Regensburg (DE); BRAUN, Michaela, 93047 Regensburg (DE); BRECH, Helmut, 93138 Lappersdorf (DE); ROPOHL, Jan, 93049 Regensburg (DE); ZIGLDRUM, Matthias, 93047 Regensburg (DE)
(74) Representative: JENSEN & SON

(57) **Abstract**

In an embodiment, a Group III nitride-based semiconductor device comprises a multilayer Group III nitride-based structure comprising a first major surface; a source electrode, a gate electrode and a drain electrode arranged on the first major surface, wherein the gate electrode is laterally arranged between the source electrode and the drain electrode and a metallization structure arranged on the first major surface. The metallization structure comprises an electrically insulating layer arranged on the source electrode, the gate electrode and the drain electrode and a conductive redistribution structure electrically connected to the source electrode, the gate electrode and the drain electrode. One or more cavities are located in the electrically insulating layer of the metallization structure.

## Description

### BACKGROUND

To date, transistors used in power electronic applications have typically been fabricated with silicon (Si) semiconductor materials. Group III-N semiconductor devices, such as gallium nitride (GaN) devices, are now emerging as attractive candidates to carry large currents, support high voltages and to provide very low on-resistance and fast switching times.

Further improvements to Group III nitride RF power devices for fast switching times are desirable.

### SUMMARY

According to the invention, a Group III nitride-based semiconductor device comprises a multilayer Group III nitride-based structure comprising a first major surface, a source electrode, a gate electrode and a drain electrode arranged on the first major surface, wherein the gate electrode is laterally arranged between the source electrode and the drain electrode, and a metallization structure arranged on the first major surface. The metallization structure comprises at least one electrically insulating layer arranged on the source electrode, the gate electrode and the drain electrode and a conductive redistribution structure that is electrically connected to the source electrode, the gate electrode and the drain electrode. One or more cavities are located in the electrically insulating layer of the metallization structure.

In order to fabricate Group III-nitride RF power devices optimized for fast switching times, reduced device terminal as well as inter-metallization capacitances are provided. These are achieved using the structures of the Group II nitride-based semiconductor devices and methods described herein.

The metallization layer includes at least one electrically insulating layer and a conductive redistribution structure. The conductive redistribution structure is electrically conductive and may comprise one or more lateral or horizontal conductive layers and one or more vertical conductive vias that extend between one of the source, gate and drain electrodes and the conductive layers, or that extends between the conductive layers. One or more electrically insulating layers are arranged between the conductive layers and the conductive vias extend vertically through the electrically insulating layers. The conductive redistribution structure may provide a conductive redistribution structure for each of the source, gate and drain electrodes that are electrically insulated from one another by the electrically insulating layer(s). The conductive redistribution structure may be formed of tungsten and/or copper. Tungsten may be used for the lower conductive layers and vias and copper for upper conductive layers and vias of the metallization structure. More generally, any metallization that is suitable for damascene based structuring can used for lower or upper conductive layers.

The electrically insulating layer can also be referred to as a dielectric layer and may comprise two or more sublayers, each formed of an electrically insulating or dielectric material, such as a silicon oxide or a silicon nitride.

In some embodiments, the cavity or void is filled with a gas or a vacuum, for example originating from the processing environment. In some embodiments, the content of the cavity, e.g. the gas or vacuum and consequently the cavity has a dielectric constant that is lower than a dielectric constant of the electrically insulating layer. The cavity is an enclosed and sealed volume that is bounded by the electrically insulating material or in some embodiments, electrically insulating material and conductive material.

The provision of void or cavity structures which are integrated in the metallization structure is used to reduce the capacitance of the Group III nitride-based semiconductor device, for example RF Power Group III-N Transistor such as a HEMT. The dielectric material is partially removed between metal lines of the metallization structure to produce voids or cavities within the dielectric and reduce parasitic fringing capacitances. As the void structures are empty or filled with appropriate material, they effectively reduce the dielectric constants of the dielectrics in which they are integrated. Reduction of dielectric constant can be e.g. a reduction from k=3.7 to k=1.0 in the case where SiO₂ is replaced by a gas or vacuum.

One or more of the cavities may be arranged at various positions within the metallization structure, for example in a region that is expected to have a higher electric field to provide a local reduction in the dielectric constant of the metallization structure. In some embodiments, a cavity is arranged laterally between the source electrode and the gate electrode. Separately or in addition, a cavity may be arranged laterally between the gate electrode and the drain electrode. Separately or in addition, a cavity may be positioned above the gate electrode. Separately or in addition, the cavity may have an elongate form having a length that extends substantially parallel to the gate electrode.

For example, in some embodiments, one cavity is located laterally between the source electrode and the gate electrode and a second cavity that is separate from the first cavity is arranged laterally between the gate electrode and the drain electrode. In another example one cavity is located laterally between the source electrode and the gate electrode and additionally extends above the gate electrode. The portion which extends above the gate electrode may be vertically spaced apart from the gate electrode by an intervening portion or sublayer of the electrically insulating layer. This cavity has an upturned L- shape with a vertical and transverse portion. In another example, a cavity is located laterally between the source electrode and the gate electrode, extends over the gate electrode and is located laterally between the gate electrode and the drain electrode. This cavity can be considered to have an upturned U-shape with two vertical portions linked by a transverse portion.

In some embodiments, the cavity is bounded on all sides by material of the electrically insulating layer to create an enclosed sealed volume that may be filled with a gas or vacuum. The electrically insulating layer may comprise a plurality of sublayers, each formed of an electrically insulating material. In some embodiments, a recess is formed in a first sublayer that forms side walls and a base of the cavity and a second sublayer forms a cap that extends between the side walls of the recess to seal the cavity and formed an enclosed space or void. In some embodiments, the base may be formed by a first sublayer, the sidewalls formed in a second sublayer arranged on the first sublayer and a cap that seals the cavity is provided by a third sublayer that is arranged on the second sublayer that extends between the sidewalls. The sublayers may have the same composition, e.g. silicon oxide or differing compositions, e.g. silicon oxide or silicon nitride.

The source electrode, the gate electrode and the drain electrode may have an elongate stripe-like form having a longest direction that extends parallel to the first surface each substantially parallel to one another. The source electrode, gate electrode and drain electrode may be referred to as a source finger, gate finger and drain finger, respectively.

The source electrode, gate electrode and drain electrode typically provide one transistor cell of a plurality of transistor cells which are electrically coupled in parallel by the metallization structure, whereby the source electrode and/or drain electrode may be common to neighbouring ones of the transistor cells such that a repeating order of source electrode, gate electrode, drain electrode, gate electrode, source electrode is formed on the first major surface.

In some embodiments, the Group III nitride-based semiconductor device further comprises a field plate. In some embodiments, the field plate is arranged on the first major surface between and spaced apart from the gate electrode and the drain electrode. In some embodiments, a cavity is arranged laterally between the field plate and the drain electrode and/or is positioned above the field plate. The field plate may be coupled to the source electrode.

In some embodiments, a single cavity is located laterally between and laterally spaced apart from the field plate and the drain electrode. In some embodiments, a single cavity is located laterally between and laterally spaced apart from the field plate and the drain electrode and further extends above the field plate. The cavity may be vertically spaced apart from the underlying field plate by a portion of the electrically insulating layer. This cavity can be considered to have an upturned L-shape with a vertical portion and a transverse portion. In some embodiments, a single cavity is located so as to be positioned laterally between the field plate and the drain electrode and extend above the field plate, above the gate electrode and laterally between the gate electrode and the source electrode. The cavity may be vertically spaced apart from the underlying field plate and gate electrode by a portion of the electrically insulating layer. This cavity can be considered to have an upturned U-shape with a transverse portion extending between two vertical portions.

The cavity may include two or more transverse portions that are spaced apart from one another along the length of the gate electrode and field plate by regions of the electrically insulating layer such that one or more conductive vias can be positioned in the spacing between neighbouring ones of the transverse portions to enable an electrical contact to the gate electrode and/or field plate to be provided intermediate the length of the gate electrode and/or field pate.

In some embodiments, at least two discrete cavities are arranged in the metallization structure in a stacked arrangement. The at least two discrete cavities may be arranged vertically on top of one another or have an offset stacked arrangement. The cavities may be arranged between neighbouring conductive layers and/or neighbouring conductive vias of the metallization structure.

In some embodiments, the metallization structure comprises a lateral gate redistribution structure that is electrically connected to the gate electrode by one or more gate vias. In embodiments including a field plate, the metallization may include a lateral field plate redistribution structure that is electrically connected to the field plate by one or more field plate vias.

The lateral gate redistribution structure may be arranged above the active switching area of the transistor device and intermediate the length of the gate electrode, the source electrode and the drain electrode. In embodiments including a field plate, the lateral field plate redistribution structure and the lateral gate redistribution structure may be arranged above the active switching area of the transistor device and intermediate the length of the field plate, the gate electrode, the source electrode and the drain electrode.

In some embodiments, the cavity or at least one of a plurality of cavities or a portion of the cavity or of at least one of the cavities is arranged vertically between the gate electrode and the lateral gate redistribution structure and/or vertically between the field plate and the lateral field plate redistribution structure.

In some embodiments, the lateral field plate redistribution structure extends over and is vertically spaced apart from the gate electrode. The lateral field plate redistribution is vertically spaced apart and electrically insulated from the underlying gate electrode by an intervening portion of one or more of the electrically insulating layers.

In some embodiments, the source electrode is electrically coupled to the lateral field plate redistribution structure by one or more source conductive vias.

In some embodiments, the source electrode, the gate electrode, the drain electrode and the field plate are elongate and each have a longest dimension that extends in a longitudinal direction and parallel to the first major surface. The lateral field plate redistribution structure comprises a plurality of transverse sections spaced at intervals in the longitudinal direction, each transverse section extending over and being vertically spaced apart from the gate electrode and being electrically coupled to the field plate by one of the field plate conductive vias. The transverse sections may extend perpendicularly to the longitudinal direction.

The transverse sections of the lateral field plate redistribution structure and of the lateral gate redistribution structure are arranged above the active switching area of the transistor device and intermediate the length of the field plate, the gate electrode, the source electrode and the drain electrode.

In some embodiments, the lateral field plate redistribution structure further comprises a longitudinal section positioned above the field plate and extending substantially parallel to the longitudinal direction and to the longest dimension of the field plate. The longitudinal section is connected to the transverse sections. The longitudinal and transverse sections may be coplanar and integral, for example patterned from a conductive layer.

In some embodiments, the lateral gate distribution structure comprises a plurality of transverse sections spaced at intervals in the longitudinal direction, each transverse section being vertically spaced apart from the gate electrode and electrically coupled to the gate electrode by one of the gate conductive vias. The transverse sections may extend perpendicularly to the longitudinal direction. The transverse section(s) of the lateral gate redistribution structure are interleaved with the transverse sections of the lateral field plate distribution structure so that an alternating arrangement, i.e. an arrangement of alternate gate and field plate transverse portions, is formed in the longitudinal direction.

The transverse sections of the lateral gate redistribution structure are arranged above the active switching area of the transistor device and intermediate the length of the field plate, the gate electrode, the source electrode and the drain electrode.

In some embodiments, the transverse sections of the lateral gate redistribution structure extend over and are vertically spaced apart from the source electrode and are electrically connected to a gate runner that is positioned on an opposing side of the source electrode from the gate electrode.

In some embodiments, the multilayer Group III nitride-based structure comprises a Group III nitride channel layer and a Group III nitride barrier layer arranged on the Group III nitride channel layer and forming a heterojunction therebetween capable of supporting a two-dimensional charge gas, wherein the source electrode, the gate electrode and the drain electrode are arranged on or in the Group III nitride barrier layer.

The channel layer may be formed of GaN and the barrier layer may be formed of AIGaN.

The semiconductor device may be a transistor device, for example a HEMT (High Electron Mobility Transistor) and may be a depletion mode or an enhancement mode device.

The gate electrode may form a Schottky contact to the Group III nitride barrier layer. The gate electrode may have a recessed structure or T-shaped or Gamma-shaped structure. In some embodiments, the gate electrode comprises a p-doped Group III nitride layer arranged on the first major surface of the Group III nitride structure and a gate metal layer arranged on the p-doped Group III nitride layer. The gate metal layer and the p-doped Group III nitride layer may each have the form of a finger. The p-doped Group III nitride layer be arranged in a gate recess formed in the first major surface of the Group III nitride structure.

In some embodiments, the metallization structure further comprises an upper electrically insulating layer and an upper conductive redistribution structure and at least one cavity is arranged in the upper electrically insulating layer.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a Group III nitride-based semiconductor device.
Figure 2, which includes figures 2A to 2F, illustrates a metallisation structure of a Group III nitride-based semiconductor device, whereby
Figure 2A illustrates a plan view of the front surface,
Figure 2B illustrates a cross-sectional view along line A-A indicated in figure 2A,
Figure 2C illustrates a cross-sectional view along the line B-B indicated in figure 2A,
Figure 2D illustrates a cross-sectional view along the line C-C indicated in figure 2A,
Figure 2E illustrates a top view of the metallization structure, and
Figure 2F illustrates a top view of the metallization structure.
Figure 3 illustrates a cross-sectional view of a metallization structure of a Group III nitride-based semiconductor device.
Figure 4 illustrates a cross-sectional view of Group III nitride-based semiconductor device.
Figure 5, which includes figures 5A to 5F, illustrates a method for fabricating a cavity in a semiconductor substrate and a cavity in a through substrate via.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device has a negative threshold voltage which means that it can conduct current at zero gate voltage. These devices are normally on. An enhancement-mode device has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AIGaN refers to an alloy described by the formula AlₓGa₍₁₋ₓ₎N, where 0 < x < 1.

To address a wide application space at high operation frequencies it is desirable to improve the performance and energy efficiency of an RF Power transistor device particularly III-Nitride based RF transistors. According to the invention the highfrequency performance is significantly improved by a reduction of Cds, Cgd and Cgs. This is realized by a modification of the metallization scheme implemented in dense dielectric materials of standard dielectric constant. whilst avoiding the use of a low-k dielectric material in the metallization structure. Moreover, in certain device concepts such as transistors with source connected field plate (SFP or FP) a substantial increase in Cds compared to non-FP transistors is achieved.

A capacitance reduction of an RF Power III-N Transistor is provided based on the provision of void or cavity structures which are integrated in the metallization structure. The dielectric material is partially removed between metal lines of the metallization structure to produce voids or cavities within the dielectric and reduce parasitic fringing capacitances. In some embodiments, patterning void structures simultaneously in self-alignment to existing metallization features is avoided and the metal fill + liner selectively removed later to form sealed voids for local reduction of dielectric constant in high electric field regions.

A full dielectric encapsulation is provided while creating effective low-k dielectric media in areas of high electric field. These media are formed by standard dielectrics such as silicon dioxide or silicon nitride or combinations thereof and which have integrated void structures. As the void structures are empty or filled with appropriate material, they effectively reduce the dielectric constants of the dielectrics in which they are integrated. Reduction of dielectric constant can be e.g. a reduction from k=3.7 to k=1.0 in the case where SiO₂ is replaced by a gas or vacuum. Other reductions in dielectric constant are possible.

The voids are integrated into a metallization stack of conductive and dielectric layers. The patterning of the void structures is done simultaneously with that of a metallization feature while an extra lithography step is applied to selectively empty these features from metal which shall become the voids.

Significant reduction of Cds, Cdg, Cgs is achieved by creating effectively reduced dielectric constants of the dielectrics inbetween drain-, gate-, source metal and substrate. The void approach can be applied to an industry-standard metallization scheme. No low-k dielectric material has to be available. However, the approach can also applied to metallizations using low-k dielectric materials. Void region definition can be self-aligned to critical neighbouring metal (e.g. drain metallization stack) by using a common reticule/mask with intrinsic self-alignment capability.

In some embodiments, void regions are formed by creating tungsten or copper single- or dual damascene metal features including their corresponding barrier systems and selectively emptying these metallization features at lithographically-defined locations with the help of isotropic wet- and plasma chemical processes.

In one implementation a void region is defined by a tungsten filled metal line and/or via structure becoming emptied at a process step after creating and surface-passivating the structure.

In another implementation a void region is defined by a copper filled metal line and/or via structure becoming emptied at a process step after creating and surface-passivating this structure.

As the dummy metal structures and the device functional metal structures are formed with the same process sequence, the void production process can be carried out using only the following 3 steps: selection of the dummy metal structures from the functional ones by photo lithography and RIE based opening of a passivation layer, wet- and dry chemical removal of the metal fill + barrier liner of the dummy metallization (the "emptying process") and sealing of the opens of the passivation layer by a PE-CVD SiO2 or SiN deposition step with low conformality.

The positive effects on integrated passive structures and devices include improved inductor quality factor due to the reduction of eddy currents in the substrate material if an array of voids is integrated between inductor and substrate, the integration of suitable void structures into the metallization dielectric stack significantly reduces the capacitive coupling of drain and gate wiring to the substrate and mutual coupling between those. Structures exhibiting voids or locally changed mechanical properties can be used to influence the mechanical properties of e.g. silicon chips (breakage strength engineering, wafer bow engineering). Such structures can also be used as crack stop layers at chip edge to facilitate the dicing process.

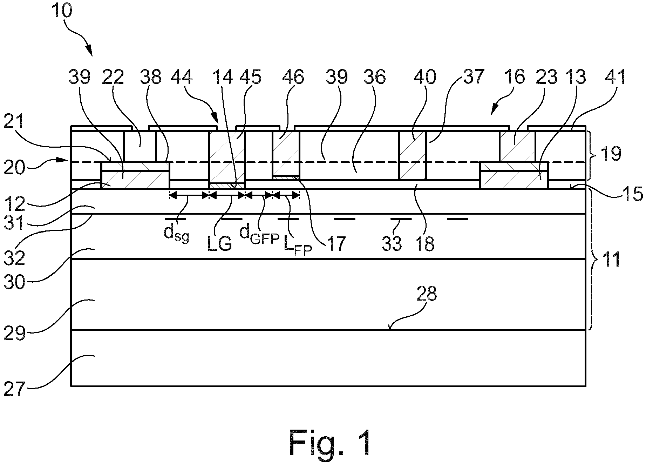

Figure 1 illustrates a schematic cross-sectional view of a Group III nitride-based device 10 according to an embodiment. The Group III nitride-based device 10 includes a Group III nitride-based layer 11 which includes a plurality of sublayers, a first ohmic contact 12, a second ohmic contact 13 and a gate electrode 14, which are arranged on a first major surface 15 of the Group III nitride-based layer 11. The Group III nitride-based device 10 may be a transistor device 16 such as a High Electron Mobility Transistor (HEMT). In embodiments in which the Group III nitride device 10 is a transistor device 16, the first ohmic contact 12 may be a source electrode and the second ohmic contact 13 may be a drain electrode. The gate electrode 14 is arranged laterally between the source electrode 12 and the drain elecrode13. In some embodiments, the Group III nitride-based device 10 also includes a field plate 17 that is positioned on the first major surface 15 and laterally between and spaced apart from the gate electrode 14 and the drain electrode 13. The source electrode 12, drain electrode 13 and gate electrode 14 have an elongate finger form in plan view and extend substantially parallel to one another on the first major surface 15.

The Group III nitride-based device 10 includes a metallization structure 20 arranged on the first major surface that comprises an electrically insulating layer 19 arranged on the source electrode 12, the drain electrode 13 and the gate electrode 14 and an electrically conductive redistribution structure 44 for each of the source electrode 12, the gate electrode 14 and the drain electrode and also for the field plate 17 in embodiments including

A first passivation layer 18 is arranged on the first major surface 15 of the Group III nitride-based layer 11 and the electrically insulating layer 19 is arranged on the first passivation layer 18. The source electrode 12, the gate electrode 14 and the drain electrode 13 extend through the first passivation layer 18, whereas the field plate 17 is arranged on the first passivation layer 18 and spaced apart from the underlying Group III nitride-based layer 11 by the first passivation layer 18. In some embodiments, the source electrode 12, the gate 14 and the drain electrode 15 are in direct contact with the Group III nitride-based layer 11.

The ohmic contact of each the source electrode 12 and drain electrode 13 comprises an upper conductive surface 21 that is positioned within the second passivation layer 19. The source and drain electrodes 12, 13 may be fabricated at substantially the same time and are fabricated before the fabrication of the gate electrode 14 and the field plate 17. The gate electrode 14 includes a gate via 45 that extends through the entire thickness of the electrically insulating layer 19. The field plate 17 also includes a field plate via 46 that extends through the electrically insulating layer 19.

In some embodiments the gate electrode 14 and the gate via 45 are integral and formed in a single process and the field plate 17 and the field plate via 46 are integral and formed in a single process. In some embodiments, the gate electrode 14 and the field plate 17 are formed first, the electrically insulating layer 19 deposited and then the gate via 45 is formed on the gate electrode 14 and the field plate via 46 on the field plate 17.

In some embodiments, the gate electrode 14 forms a Schottky contact to the Group III nitride layer 11. In other embodiments, the gate electrode 14 includes a gate oxide or a gate dielectric arranged between the metallic gate electrode and the Group III nitride layer 11. In some embodiments, the gate electrode 14 further comprises a p-doped Group III nitride layer arranged between the first major surface 15 and the metal gate electrode 14. The gate electrode 14 may have a recessed structure. The p-doped Group III nitride layer and/or recessed gate structure may be used to provide an enhancement mode transistor device 10 which is normally off.

A conductive via 22 is arranged on the source electrode 12 and a conductive via 23 is positioned on the drain electrode 13, in particular on the upper conductive surface 21. The conductive vias 22, 23 extend through the electrically insulating layer 19. The conductive via 22, 23 has a lateral extent which is less than the lateral extent of the conductive surface 21 of the respective electrode 12, 13.

The Group III nitride-based layer 11 may include a multi-layer Group III nitride structure positioned on a support substrate 27 which has a growth surface 28 which is capable of supporting the epitaxial growth of at least one Group III nitride layer. The support substrate 27 may be monocrystalline silicon substrate, for example a <111 > or <110> silicon wafer or a monocrystalline sapphire substrate.

The multilayer Group III nitride structure 11 may include a Group III nitride buffer structure 29 arranged on the growth surface 28, a Group III nitride channel layer 30 arranged on the Group III nitride buffer structure 29 and a Group III nitride barrier layer 31 arranged on the Group III nitride channel layer 30. The Group III nitride barrier layer 31 has a different composition and bandgap to the Group III nitride channel layer 30 such that a heterojunction 32 is formed therebetween. For example, the Group III nitride channel layer 30 may comprise gallium nitride and the Group III nitride barrier layer 31 may comprise aluminium gallium nitride. The heterojunction 32 is capable supporting a two-dimensional charge gas which is indicated schematically in the in figure 1 by the dashed line 33. The source electrode 12 and drain electrode 13 13 form an ohmic contact with the two-dimensional charge gas 33.

A typical buffer structure 29 for a silicon substrate includes a AIN starting layer, which may have a thickness of several 1 00nm, on the silicon substrate followed by a AₗₓGa₍₁₋ₓ₎N layer sequence, the thickness again being several 100nm's for each layer, whereby the Al content of about 50-75% is decreased down to 10-25% before the GaN layer of AIGaN back barrier is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thick-ness of the AIN layer and AlₓGa₍₁₋ₓ₎N is in the range of 2-25nm. Depending on the desired breakdown voltage the super-lattice may include between 20 and 100 pairs. Alternatively, an AlₓGa₍₁₋ₓ₎N layer sequence as described above can be used in combination with the above mentioned superlattice.

As is indicated by the dotted line 35 in figure 1, in some embodiments, the electrically insulating layer 19 of the metallization structure 20 includes two sublayers. The lower sublayer 36 is positioned on the Group III nitride-based barrier layer 30 and, during manufacture of the Group III nitride-based device 10, forms a planar surface with the conductive surface 21 of the base portion 20 of the source and drain electrodes 12, 13 before the deposition of the upper sublayer 37 onto the planar surface. The lower and upper sublayers 36, 37 may have the same composition, for example silicon oxide, and may be formed using a TEOS (Tetraethyl orthosilicate) process.

The first passivation layer 18 is positioned between the upper surface of the Group III nitride-based barrier layer 30 and has a different composition to first electrically layer 19. For example, the first passivation layer 18 may be formed of silicon nitride.

In some embodiments, the passivation layer 18 is formed of a so called "high-k" dielectric, which has a higher dielectric constant compared to silicon dioxide, for example a hafnium- or zirconium-based dielectric materials such as hafnium silicate, hafnium dioxide, zirconium silicate and zirconium dioxide. This enables the thickness d_{FP} of the passivation layer 18 between the lower surface of the field plate 17 and the first major surface 15 to be increased, leakage to be avoided and reliability to be improved for these thin passivation layers.

The formation of this planarised surface, represented by the dotted line 35, enables the subsequent layers built up upon it to be planar. This enables the gate electrode 14 and field plate 17 to be formed using photolithographic techniques after the fabrication of the source and drain electrodes 12, 13, whereby the photoresist mask and deposition processes for fabricating at least a base portion of the gate electrode 14 and field plate 17 can be carried out on this planarised surface 35.

This method enables the photoresist layer for the gate 14 and field plate 17 to be more accurately structured, since it is formed on a planar surface 35 and can be formed after the source and drain electrodes 12, 13 are formed to the multilayer Group III structure 11, which typically involves higher processing temperatures. As a result of the more accurate structuring of the photoresist layer, the dimensions and position of the gate electrode 14 and field plate 17 can be more accurately controlled. This also enables the distance d_{SG} between the ohmic source electrode12 and the gate electrode 14, as measured at the base of the source electrode 12 and gate electrode 14, to be reduced and to be reliably produced at this reduced length. The gate to source distance d_{SG} may be less than 0,5 µm, for example 250nm or less in order to lower RDSON and enhance device performance. The more accurate structuring of the photoresist layer, the position of the field plate 17 with respect to the gate, d_{GFP}, can also be more reliably controlled and may also be less than 0,5 µm, for example 250nm or less.

Additionally, the critical dimension control of the gate process is improved to enhance manufacturability and device performance. The gate length LG and/or the length of the field plate LFP may also be less than 0,5 µm, for example 250nm or less. This high precision patterning of the gate electrode is enabled as the photoresist processes of the gate and field plate are not affected by topography steps created by the source and drain electrodes 12, 13 due to the formation of the planarized surface 35 after the formation of the base portion 16. Such topography steps would impair the local uniformity of the involved anti-reflection-coating and resist coating processes and would degrade the depth-of-focus of the lithographic exposure process. In effect the control of small dimension lithographic structures would be severely limited.

In some embodiments, a base of the gate electrode and a base of the field plate each have a width of 50 nm to 400 nm, or 200 nm to 350 nm, for example around 250nm and the distance between the gate electrode and the field plate at the closest point is 100 nm to 400 nm, or 200 nm to 350 nm, for example around 250 nm.

The source and drain electrodes 12, 13 may include a single composition or may include a stack of two or more layers 38, 39 of differing composition. In some embodiments, the source electrode 12 and the drain electrode 13 each include two regions of differing composition that are coplanar. In some embodiments, a well 38 comprising a metal or alloy of a first composition extending into a lower portion 39 comprising a metal or alloy of a second different composition that provides the peripheral region of the upper conductive surface 21.

In some embodiments, the top layer or well 38 comprises a conductive barrier material and the lower portion 39 comprises an ohmic contact material. An ohmic contact material is material which forms an ohmic contact to the Group III nitride material of the uppermost Group III nitride layer of the multilayer Group III nitride structure 11. In some embodiments, the conductive barrier material comprises titanium nitride and the ohmic contact material comprises aluminium or aluminium copper alloy or a titanium aluminium alloy.

The metallization structure 20 further comprises one or more cavities or voids 40 that are located in the metallization structure 20 and that are bounded and sealed by electrically insulating material of the metallization structure 20. Each cavity 40 is an enclosed or sealed volume that is devoid of the material or the electrically insulating layer 19 and can be thought of as "empty". The cavity 40 has a dielectric constant that is lower than a dielectric constant of the material of the electrically insulating layer 19 and other electrically insulating layers of the metallization structure In some embodiments, the cavity 40 is filled with a gas or a vacuum, for example provided by the processing atmosphere immediately prior to sealing the cavity, that has a dielectric constant that is lower than a dielectric constant of the material of the electrically insulating layer 19 and other electrically insulating layers of the metallization structure. For example, As the void structures are empty or filled with a material having a lower dielectric constant than the material in which they are located, the void structure effectively reduces the dielectric constant of the dielectrics in which they are integrated. A reduction of dielectric constant from k=3.7 to k=1.0 can be achieved if a volume of SiO₂ is replaced by a void, i.e. a cavity including a gas or vacuum.

The one or more cavities 40 may be used to provides a localised reduction in the dielectric constant of the electrically insulating material of the metallization structure 20. The one or more cavities 40 may be located at regions subjected to a higher electric field and serve to reduce the values of the drain source capacitance, Cds, gate drain capacitance Cgd and gate source capacitance Cgs which in turn improves the performance and energy efficiency of the Group III nitride-based device 10 and reduce the Rdson of the transistor device 10.

One or more of cavities 40 may be located at different positions within the metallisation structure 20. Figure 1 illustrates an embodiment in which a cavity 40 is positioned in the first electrically insulating layer 19 such that it is laterally positioned between and spaced apart from the field plate 17 and the drain electrode 13. The base of the cavity 40 is formed by the first passivation layer 18. Sidewalls of the cavity 40 are formed by the electrically insulating layer 19 and the two sublayers 36, 37. The cavity 40 is covered and sealed at the top side by a second passivation layer 41 which is positioned on the electrically insulating layer 19. The cavity 40 is substantially coplanar with the field plate via 46 and structure of the drain electrode 13 and drain vis 13. The first and second passivation layers 18, 41 may be formed of silicon nitride and the first electrically insulating layer 19 may be formed of silicon oxide, for example. The surfaces surrounding the cavity 40 maybe formed by electrically insulating material having one or more than one composition to create an entirely enclosed and sealed void in the metallization structure 20.

In place of a cavity 40 positioned between the field plate 17 and the drain electrode 13, one or more cavities may be arranged laterally between and spaced apart from the source electrode 12 and the gate electrode 14 and laterally between the gate electrode 14 and the drain electrode 13, in embodiments in which the Group III nitride-based transistor device 10 does not include a field plate. In some embodiments, one or more cavities 40 may be positioned above the gate electrode 14. For example, the gate electrode 14 may be formed of an elongate gate finger which is positioned on the first major surface 15 of the Group III nitride-based layer 11. Two or more gate vias 45 may be spaced at intervals along the length of the gate finger 14 and the cavity may be positioned between and spaced apart from two or more of these gate vias 45.

In some embodiments, one or more of the cavities 40 may have a form such that a first portion of the cavity is positioned laterally between the source electrode 12 and the gate electrode 14 and extends into a second portion that is positioned above the gate electrode 14. The cavity is then spaced apart vertically from the elongate gate electrode 14 by the intervening portion of the electrically insulating layer 19. In some embodiments, a single cavity may be positioned laterally between the source electrode 12 and the gate electrode 14, extend over and above the gate electrode 14 and over and above the field plate 17 and also be positioned laterally between the field plate 17 and the drain electrode 13. The cavity may have an upturned U-shape with a transverse portion extending between the upper ends of two vertical portions.

Portions of a single cavity 40 may be arranged in different layers of the metallisation structure 20.

In some embodiments, two or more discrete cavities 40 are arranged in the metallisation structure which may have a stacked arrangement. The two or more discrete cavities 40 may be either arranged directly above one another or have an offset stacked arrangement.

The one or more cavities 40 may also have different lateral forms. For example, the cavity 40 may have an elongate form and extend substantially parallel to the longest length of an elongate gate electrode 14 or elongate field plate 17, for example. In some embodiments, the cavity 40 may have an elongate portion which extends substantially parallel to the longest length of the gate electrode 14 and one or more transverse portions which extend perpendicularly from the elongate portion and vertically above the gate electrode 14. The transverse portion has a dimension in the longitudinal direction that is less than the longest dimension of the gate electrode. For example, one transverse portion may be arranged between neighbouring gate vias 45 that extend to the gate electrode 14.

The one or more cavities 40 may be located in the metallisation structure 20 in order to reduce the values of the drain source capacitance, Cds, gate drain capacitance Cgd and gate source capacitance Cgs which in turn improves the performance and energy efficiency of the Group III nitride-based device 10. The dielectric material of the metallization structure is partially removed, for example between metal regions of the metallization structure, to produce voids or cavities within the dielectric and reduce parasitic fringing capacitances. As the void structures are empty or filled with appropriate material, they effectively reduce the dielectric constants of the dielectrics in which they are integrated. Reduction of dielectric constant can be e.g. a reduction from k=3.7 to k=1.0 in the case where SiO₂ is replaced by a gas or vacuum. At the same time, a full dielectric encapsulation is provided while creating effective low-k dielectric media which may be positioned in areas of high electric field within the metallization structure. Reduction of Cds, Cdg, Cgs is achieved by creating effectively reduced dielectric constants of the dielectric material between drain-, gate-, source and field plate metal and the substrate.

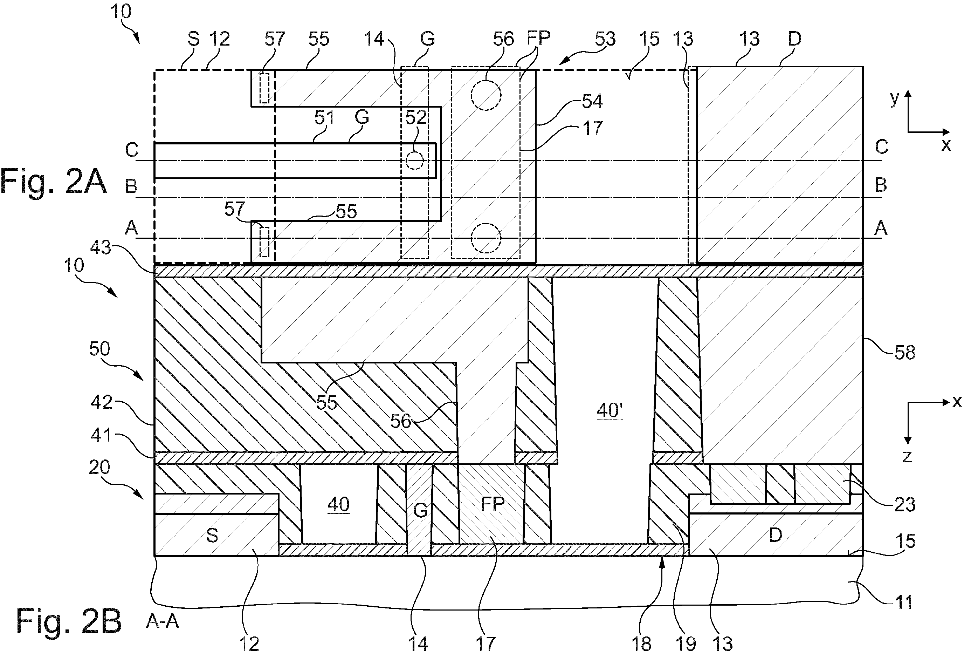

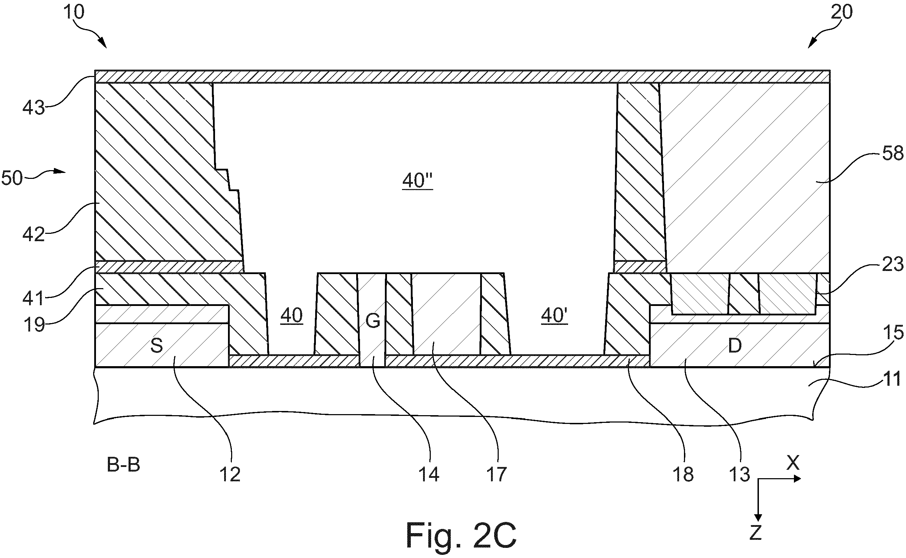

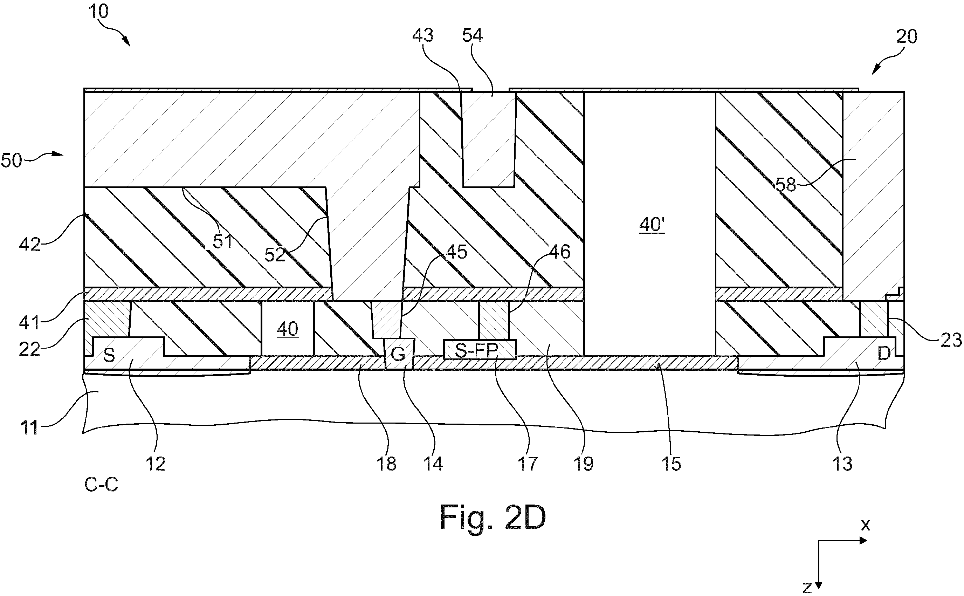

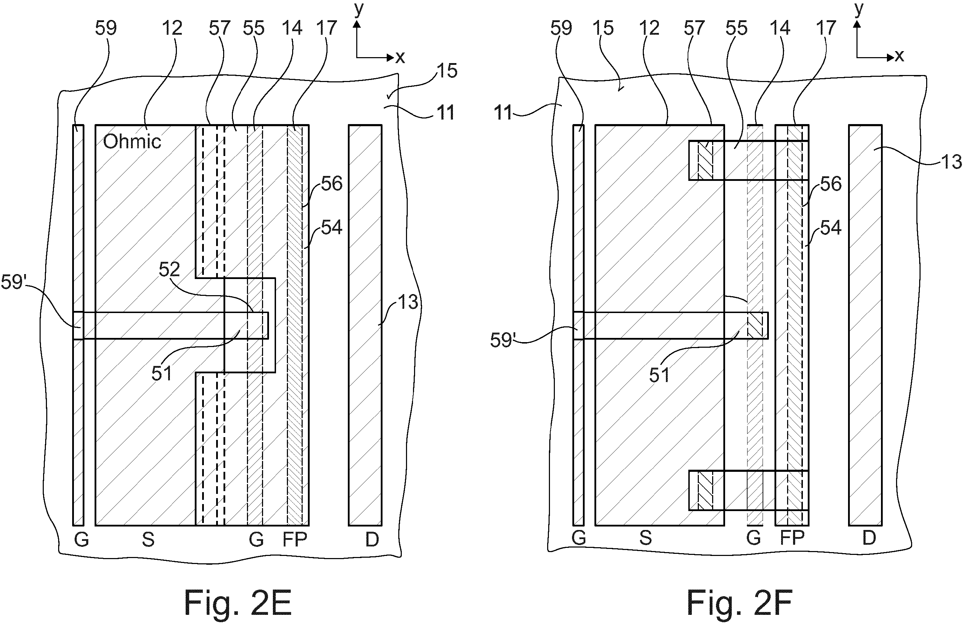

Figure 2, which includes figures 2A to 2F, illustrates views of the metallisation structure 20 of a Group III nitride-based semiconductor device 10 according to another embodiment. Figure 2A illustrates a plan view of the first major surface 15, figure 2B illustrates a cross-sectional view along line A-A indicated in figure 2A, figure 2C illustrates a cross-sectional view along the line B-B indicated in figure 2A and figure 2D illustrates a cross-sectional view along the line C-C indicated in figure 2A. Figures 2E and 2F illustrates two plane views of the metallization structure 20.

Referring to the plan view of figure 2A, the source electrode 12 gate electrode 14 field plate 17 and drain electrode 13 each have an elongate stripe-like structure and extend substantially parallel to one another on the first major surface 15 of the Group III nitride layer 11. In the view illustrated in figure 2A, the longest dimension of the electrodes extends in the Y direction using the Cartesian coordinate system and the source electrode 12, gate electrode 14, field plate 17 and drain electrode 13 are spaced apart from one another in the X direction. The electrodes may also be referred to as fingers.

The metallisation structure 20 includes an intermediate layer 50 which includes a plurality of sublayers. As can be seen in the cross-sectional view of figure 2B, the intermediate layer 50 of the metallisation structure 20 includes a second electrically insulating layer 42 arranged on the second passivation layer 41 and a third passivation layer 43 arranged on the second electrically insulating layer 42. The second electrically insulating layer 42 may be formed of silicon dioxide and the third passivation layer may be formed of silicon nitride. The second insulating layer 42 has a greater thickness than the third passivation layer. For example, the second insulating layer 42 may have a thickness of around 750 nm and the second and third passivation layers 41, 43 a thickness of around 50 nm. The first insulating layer 19 may have a thickness of around 350 nm.

The intermediate layer 50 comprises a gate lateral redistribution structure which is electrically conductive and which includes at least one transverse portion 51 which extends in the X direction. As can be seen in the cross-sectional view of figure 2D, the transverse portion 51 is spaced apart in the Z direction from the gate electrode 14 by a portion of the second insulating layer 42. The transverse portion 51 is electrically connected to the gate electrode 14 by a gate via 52.

The intermediate layer 50 further comprises a field plate lateral redistribution structure 53 which is electrically conductive and which comprises a longitudinal portion 54 which is positioned above and extends substantially parallel with the longest length of the field plate 17 in the Y direction and at least one transverse portion 55 which extends substantially perpendicularly from the longitudinal portion 54 in the X direction The field plate lateral redistribution structure 53 is electrically connected to the field plate 17 by one or more field plate vias 56 which can be seen in the cross-sectional view of figure 2B. In some embodiments, two or more field plate vias 56 are provided which are spaced apart at intervals along the length of the field plate 17. Each field plate via 56 is positioned at the intersection between the transverse portion 35 and the longitudinal portion 54. A plurality of transverse portions 55 are provided which are spaced at intervals along the length of the field plate 17 as can be seen in the tope views of figures 2A, 2E and 2F. The transverse portion 51 of the gate lateral redistribution structure is positioned between two of the transverse sections 55 of the field plate redistribution structure 53. The transverse portions 55 of the field plate redistribution structure and the transverse portion(s) 51 of the gate redistribution structure 55 may be substantially coplanar at positions intermediate the length of the source electrode 12, gate electrode 14 and drain electrode 13 and above the active surface of active area of the Group III nitride semiconductor device 10. The transverse portions 55 of the field plate redistribution structure and the transverse portion(s) 51 of the gate redistribution structure 55 may be located exclusively at positions intermediate the length of the source electrode 12, gate electrode 14 and drain electrode 13 and above the active surface of active area of the Group III nitride semiconductor device 10.

As can be seen in the cross-sectional view of figure 2B, the transverse portions 55 of the field plate redistribution structure 53 extend over and are spaced apart and electrically insulated from the underlying gate electrode 14 by an intervening portion of the electrically insulating layers of the metallisation structure 20, for example the second passivation layer 41 and second insulating layer 42. Both the transverse portion 51 of the gate electrode and the transverse portion 55 of the field plate redistribution structure 53 extend over the source electrode 12. The transverse portion 55 may be electrically connected to the source electrode 12 by a source via 57 which extends between the source electrode 12 and the lateral transverse portion 55 of the lateral field plate redistribution structure 53. The lateral gate redistribution structure 51 and the lateral field plate redistribution structure 53 are arranged in the second insulating layer 42 of the intermediate layer 50 of the metallization structure 20.

A conductive via 58 for the drain 13 is also provided which extends through the second insulating layer 42 and second passivation layer 41 and is electrically connected to the one or more vias 23 arranged on the drain electrode 13.

The metallization structure 20 includes one or more cavities 40 that are positioned in more or more of the insulating layers 19, 42. One or more cavities may be positioned at different locations, for example in a location having a higher electric field. For example, a first discrete cavity 40 may be arranged laterally between the source electrode 12 and the gate electrode 14 such that it is sealed at the top and bottom by the first and second passivation layers 18, 41, respectively and such that its sidewalls ore formed by the first electrically insulating layer 19. Such a structure can be seen in figures 2B and 2D. In some embodiments, the metallisation structure 20 includes a second cavity 40' which stands which is capped at its base by the first passivation layer 18 and at its top by the third passivation layer 43 and which extends through the first electrically insulating layer 19, the second passivation layer 41 and the second electrically insulating layer 43. The second cavity 40' is arranged laterally between and spaced apart from the field plate 17 and the drain electrode 13. Such a structure is illustrated in figures 2B and 2D.

Referring to the cross-sectional view along line B-B of figure 2C, it can be seen that in some embodiments, the first cavity 40 and the cavity 40' are not discrete and separate from one another but in at least one plane are in communication and connected by means of a cavity portion 40". The cavity portion 40" extends laterally over the gate electrode 14 and the field plate 17 and is formed in the second electrically insulating layer 42. The cavity portion 40" extends through the second passivation layer 41 into the cavity 40 formed in the first insulating layer 19 and into the cavity 40" in the second insulating layer 42. This portion 40" of the cavity is capped at the top by the third passivation layer 43 and at its base by the first passivation layer 18 and has sidewalls formed by the first electrically insulating layer 19, the second passivation layer 41 and the second electrically insulating layer 43. A single cavity is formed from the portions 40, 40', 40" which has an upturned U-shape in the plane illustrated in figure 2C.

Figure 2D illustrates a cross-sectional view along line C-C and illustrates a cross-sectional view of the gate redistribution structure from the gate electrode 14 which is positioned directly on the first major surface 15. The gate electrode 14 is electrically connected to the transverse portion 51 by a vertical conductive structure formed by the first gate via 45 extending through the first electrically insulating layer 19 and second via gate via 52 that extends through the second passivation layer 19 and through at least a portion of the second electrically insulating layer 43. In this plane, the longitudinal section 54 of the field plate redistribution structure 53 is spaced apart from the field plate 17 by an intervening portion of the second electrically insulating layer 42. In this plane, the cavity portion 40' extends from the first passivation layer 18 to the third passivation layer 43.

Figures 2E and 2F illustrate two top views of the Group III nitride device in which the form of the gate runner, source and drain electrodes are shown. Figure 2E illustrates a top view of a portion of the metallization structure 20.

The source electrode 12, the gate 14 and the field plate 17 and the drain electrode 13 are arranged in a lower lateral conductive layer and each have an elongate structure with a long direction extending in the longitudinal Y direction substantially parallel to one another. The lateral redistribution structure 51, 53 for the gate electrode 14 and field plate 17, respectively, are arranged in an upper conductive layer that is spaced apart from the lower conductive layer in which the source electrode, 12, gate electrode 14, drain electrode 13 and field plate 17 are formed by the intervening regions of the dielectric layer(s), i.e. the first electrically insulating layer 19, the second passivation layer 41 and the second electrically insulating layer 42.

The lateral field plate redistribution structure 51 has a U-shape formed by longitudinal portion 54 extending in the Y direction over the entire length of the field plate 17 and two transverse portions 55 which extend in the X direction and substantially perpendicularly to the longitudinal portion 54. More than two transverse portions 55 may be provided. The transverse portions 55 are spaced apart from one another in the Y direction.

Each transverse portion 55 extends from above the field plate 17 over the gate 14 to above at least region of the source electrode 12. Each transverse portion 55 is electrically coupled to the underlying source electrode 12 by an elongate conductive via 57 which extends vertically through the intervening passivation and electrically insulating layers 19, 41, 42 to the underlying source electrode 12. The transverse portions 55 and longitudinal portion 54 are electrically coupled to the field plate 17 by one or more conductive vias 46 extending between the longitudinal portion 54 and the field plate 17. In this embodiment, a single elongate via 46 is provided that extends vertically between the field plate 17 of the lower conductive layer and the longitudinal portion 54 of the field plate redistribution structure 53 in the upper conductive layer and over substantially the entire length of the field plate 17 in the Y-direction, e.g. at least over at least 90% of the entire length of the field plate 17 in the Y-direction.

The gate electrode 14 is electrically connected to a transverse conductive portion 55 of the upper conductive layer which extends in the X direction from a position above the gate electrode 14 to a position laterally adjacent the source electrode 12. The transverse portion 55 coupled to the gate 14 is laterally spaced apart from the transverse portions 55 and longitudinal portion 54 of the field plate redistribution structure 53 in the X_Y plane. The transverse portion 55 is electrically coupled to the underlying gate 14 by a via 45. The transverse portion 55 is also electrically connected to a gate runner 59 by a one or more vias 59'. The gate runner 59 is positioned laterally adjacent the source electrode 12 on the opposing side from the gate electrode 14.

This arrangement may be considered to be a fully shielded structure. In this fully shielded structure, the extent of the transverse portions 54 of the field late redistribution structure 53 in the Y-direction may be at least 50% of the length of the field plate 17 in the Y-direction, such as at least 80% thereof. This fully shielded structure allows for a particularly low Cgd.

Figure 2F illustrates a metallization structure 20 that is similar to that in figure 2E. It differs in that each of the transverse portions 54 of the lateral field plate redistribution structure 53 has a smaller extent in the longitudinal Y direction, i.e. less than 50% of the length of the field plate 17 in the Y-direction, such as less than or equal to 20% thereof. The gap between each of the transverse portions 54 and the transverse portion 51 coupled to the gate 14 is larger than in the embodiment illustrated in figure 2E. The length of the vias 57 extending between the source electrode 12 and the respective transverse portion 54 is also smaller due to the reduced width of the transverse portion 54 in the Y direction. This arrangement may be considered to be a semi shielded structure and allows for a lower Cgs.

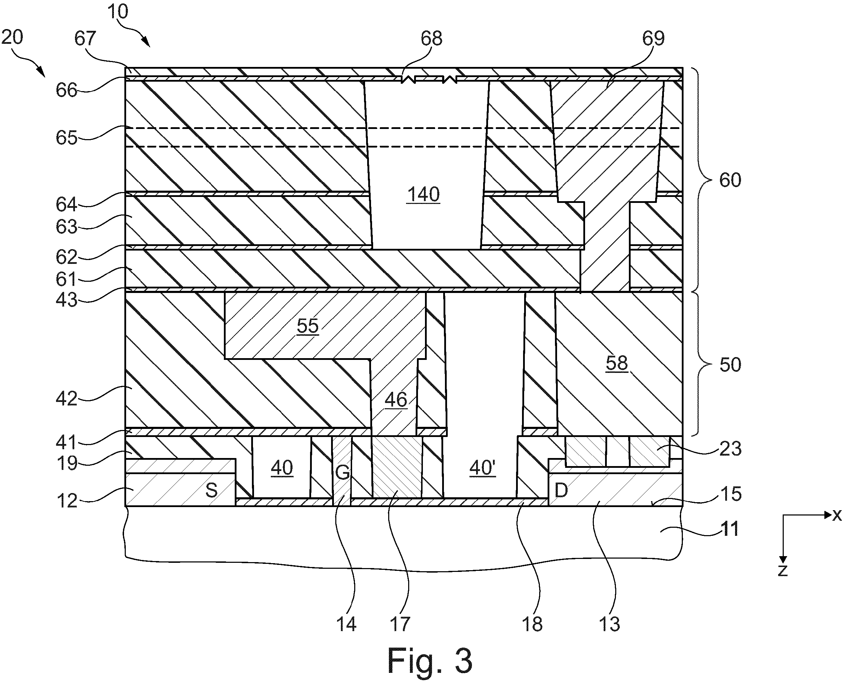

Figure 3 illustrates a cross-sectional view of the Group III nitride-based device 10 of in a plane corresponding to figure 2B. Figure 3 illustrates that in some embodiments the metallization structure 20 includes a further layer 60 which is arranged on the intermediate layer 50. The upper layer 60 comprises a third electrically insulating layer 61, a fourth passivation layer 62, a fourth electrically insulating layer 63, a fifth passivation layer 64, a fifth electrically insulating layer 65, a sixth passivation layers 66 and a sixth electrically insulating layer 67 arranged in a stack in this order on the third passivation layer 43.

The upper layer 60 also comprises a conductive redistribution structure which may include a portion of the conductive redistribution structure for each of the source electrode 12, the gate electrode 14, the drain electrode 13 and the field plate 17. In figure 3, a vertical conductive redirection structure 69 for the drain electrode 13 can be seen. The conductive vias and conductive lateral redistribution structure of the intermediate layer 50 and lower layer 19 of the metallisation structure 20 may be formed of tungsten, whereas the conductive material used for the redistribution structure of the upper layer 60 may be copper.

One or more cavities 140 may be arranged in this upper layer 60 of the metallization structure 20. In the embodiment illustrated in figure 3, a cavity 140 is arranged laterally adjacent the drain electrode 13 and its associated vertical conductive redistribution structure 69 and vertically overlaps and is vertically spaced apart from the field plate 17 and the cavity portion 40' illustrated in figure 2B. The cavity 140 may extend through two or more of the electrically insulating layers and passivation layers 61, 62, 63, 64, 65 and in this embodiment is capped at the top by the sixth passivation layer 66 and sealed at the bottom by the third electrically insulating layer 61. Also illustrated in figure 3 are gaps in the sixth passivation layer 66 which form an opening 68 to the cavity 140. The openings 68 are sealed by material of the sixth electrically insulating layer 67 which extends over and, in some embodiments, partially into the openings 68 in order to seal the openings 68 and the cavity 140.

A method for fabricating the metallization structure 20 including one or more cavities 40 formed on the front surface of the Group III nitride-based device 10 will now be described with reference to figure 3. The method may be used for forming one or more cavities in one or more of the layers 19, 50, 60 of the metallization structure 20.

A substrate 27 is provided that comprises a Group III nitride-based layer 11, a first passivation layer 18 on the first major surface of the Group III nitride-based layer and a first insulating layer 19 arranged on the first passivation layer 18, the first insulating layer 19 may have a different composition from the first passivation layer 18. A first mask layer is formed on the first insulating layer 19. The first mask layer comprises a first sublayer arranged on the first and a first photoresist sublayer on the first sublayer.

A first opening for a gate electrode 14 is formed in the first mask layer, the first opening extending through the first photoresist sublayer and through the first sublayer, a second opening for a field plate 17 is formed in the first mask layer, the second opening extending through the first photoresist sublayer and through the first sublayer and a third opening for a cavity 40 is formed in the first mask layer, the third opening extending through the first photoresist sublayer and through the first sublayer. The first insulating layer exposed by the first opening is removed and a first via for the gate electrode 14 is formed, the first via having a base formed by the first passivation layer 18. The first insulating layer19 exposed by the second opening is removed and a second via for a field plate 17 is formed, the second via having a base formed by the first passivation layer 18. The first insulating layer 19 exposed by the third opening is removed a third via for a cavity 40' is formed, the third via having a base formed by the first passivation layer 18.

The first photoresist layer is removed and a second photoresist layer is applied onto the first insulating layer that covers the second opening for the field plate 17 and the third opening for the cavity 40' and leaves the first opening for the gate electrode 14 and a region of the first insulating layer adjacent the first opening uncovered. The first passivation layer 18 exposed by first via is removed and the depth of the first via is increased such that the first via has a base formed by the Group III nitride multi-layer structure 11. The second resist layer is then removed.

An electrically conductive layer is deposited into the first via, the second via and the third via to form the gate via 45 and field plate via 46 with an integral gate electrode 14 and field plate 17. The first via 45 and the second via 46 are then covered and the conductive layer is removed from the third via. A second passivation layer 41 is applied onto the first insulating layer 19, the first via 45 and the second via 46 and covers and seals the third via to form the cavity 40'.

This method can be used to more accurately locate and control the width of the first, second and third vias. In some embodiments, the base of the first via 45 and the gate electrode 14 has a width of between 50 nm and 400 nm and/or a minimum distance between the base of the first via 45 and the second via 46 and the distance between the gate electrode 14 and the field plate 17 is between 50 nm and 400 nm.

In some embodiments, first passivation layer comprises silicon nitride and the first insulating layer comprises silicon nitride. These materials have different etching properties so that one layer can be selectively etched over the other.

The source and drain electrodes 12, 13 are already formed on the first major surface 15 of the Group III nitride-based layer 11 so that the first passivation layer 18 is located on the first major surface 15 of the Group III nitride-based layer 11 and extends between the source electrode 12 and the drain electrode 13 and the first insulating layer 19 is arranged on the first passivation layer18 and on the upper surface of the source and drain electrodes 12, 13.

The source and drain electrodes 12, 13 may be formed on the first major surface 15 of the Group III nitride-based layer 11 such that the source and drain electrodes 12, 13 extend at least partially through the first passivation layer 18 and in some embodiments into the Group III nitride layer 11, for example to the heterojunction 32. The source and drain electrode 12, 13 are then covered with a first sublayer of insulating material, e.g. sublayer 36 of the first insulating layer 19. A planarising step is carried out to form an intermediate planarized surface 35 comprising the upper surface 21 of the source electrode 12, a surface of the drain electrode 13 and the first sublayer 36. A second sublayer 37 of insulating material is formed on the planarized surface 35 and arranged on the upper surface 21 of the source electrode 12 and the drain electrode. The first and second sublayers 36, 37 form the first insulating layer 19. The vias 22, 23 to the source and/or drain electrodes 12, 13 may be formed using the first mask layer.

After depositing the conductive material into the first, second, third and fourth vias 45, 46 a planarising process may be carried out to form a planarised surface comprising isolated areas of electrically conductive material positioned in the first, second, third vias 45, 46, each isolated area of electrically conductive material being surrounded by the first insulating layer 19

The metallization structure 20 may then be built up using damascene, dual damascene tri damascene and quad damascene processes. The conductive material may be tungsten or copper as both of these materials are suitable for use in damascene methods.

In some embodiments the method continues by forming a second passivation layer 41 on the first insulating layer 19 and on the isolated areas of electrically conductive material, forming a second insulating layer 42 on the second passivation layer, the second passivation layer 41 and second insulation layers 42 having differing compositions, structuring the second insulation layer 42 to form a first trench positioned above the first via 45, the first trench having a base spaced apart from the first via 45 by a portion of the second insulating layer 42 and the second passivation layer 41, the first trench being laterally wider than the first via 45 , forming a fifth via in the base of the first trench that exposes the electrically conductive material in the first via 45 by removing the second insulation layer 42 and the second passivation layer 41, the fifth via being laterally smaller than the first trench and forming a second electrically conductive material layer in the fifth via and in the first trench.

In some embodiments, the method continues by structuring the second insulation layer 42 to form a second trench above the second via 46 and a third trench above the fourth via, the second trench having a base spaced apart from the second via 46 by a portion of the second insulating layer 42 and the second passivation layer 41, the second trench being laterally wider than the second via, the third trench having a base spaced apart from the fourth via by a portion of the second insulating layer 42 and the second passivation layer 41, the third trench being laterally wider than the third via, forming a sixth via in the second trench that exposes the electrically conductive material in the second via by removing the second insulation layer 42 in the base of the second trench, forming a seventh via in the third trench that exposes the electrically conductive material in the fourth via by removing the second insulation layer in the base of the third trench and depositing the second electrically conductive material layer into the second and third trenches and into the sixth and seventh vias.

In some embodiments, in addition to the one or more cavities 40 in the metallization structure 20 or in place of the one or more cavities 40 in the metallization structure 20, one or more cavities may be arranged in the substrate 27 on which the Group III nitride-based layer is formed.

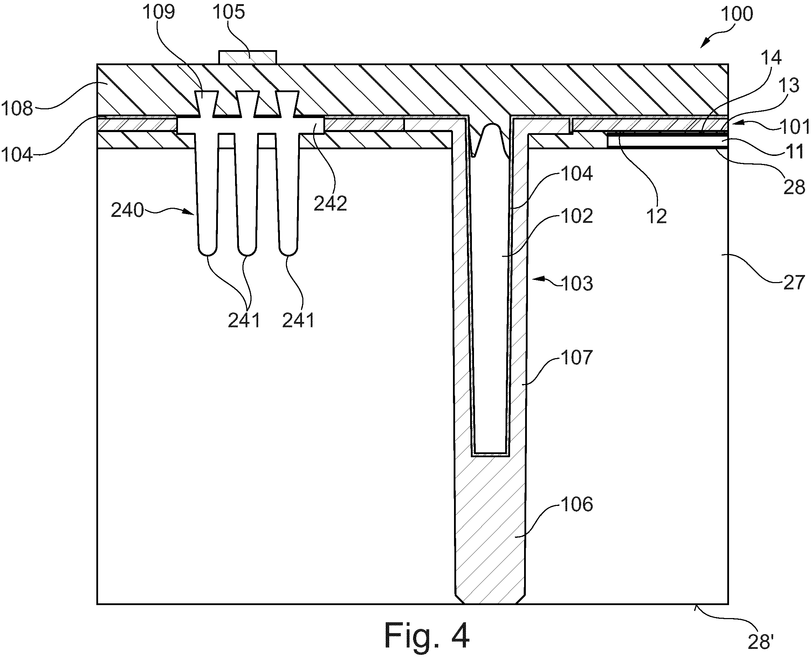

Figure 4 illustrates a Group III nitride-based semiconductor device 100. The Group III nitride-based device 100 comprises a transistor device, for example a HEMT 101 and a substrate 27 having a front surface 28, a rear surface 28' opposing the front surface 28, a Group III nitride-based layer 11 arranged on the front surface 28 in which the Group III nitride-based transistor device 101 is formed.

The front surface 28 of the substrate 27 includes an upper or growth surface which is capable of supporting the epitaxial growth of one or more Group III nitride-base layers 11. In some embodiments, the substrate 27 is a foreign substrate, i.e. is formed of a material other than Group III nitride materials that includes the upper or growth surface 28 which is capable of supporting the epitaxial growth of one or more Group III nitride-base layers. The substrate 27 may be formed of silicon and may be formed of monocrystalline silicon or an epitaxial silicon layer, for example, or sapphire.

At least one cavity 240 is arranged in a region of substrate 27 that is positioned laterally adjacent the Group III nitride-based transistor device 101. Furthermore, a via cavity 102 is arranged in a through substrate via 103 that extends from the front surface 28 to the rear surface 28' of the substrate 27. The through substrate via 103 provides an electrical connection in the form of a conductive via between the source electrode 12 of the Group III nitride-based transistor 101 and the rear surface 28' of the substrate 27, for example to a conductive layer arranged on the rear surface 28' of the substrate 27. The Group III nitride-based transistor device 101 may have the structure of the Group III nitride-based transistor device 10 illustrated in figures 1 to 3.

The through substrate via 103 comprises a first conductive portion 106 adjacent the rear surface that fills the via 103 and a second conductive portion 107 on the first conductive portion 106 that lines side faces of the via 103 and surrounds a gap that is sealed by one or more dielectric layers 108 arranged towards the top of the via 103 at the front surface 28 to form the via cavity 102. The one or more dielectric layers 108 also extend over the front surface 28 and over the transistor device 101 and may also be used as part of the metallization structure 20 for the transistor device 10. For example, the conductive prtions106, 107 may be formed as copper and at the same time as the upper layer 60 of the metallization structure 20 described with reference to figure 3.

In some embodiments, one or more dielectric layers 104 are deposited onto the conductive portions 106, 107 and surround the gap 102. In these embodiments, after deposition of the dielectric layer 108, the via cavity 102 has side walls formed entirely of the dielectric material of the layers 104, 108 and provides a completely enclosed and sealed empty void. The dielectric layer 104 may be formed of silicon nitride, for example, and be formed along with one of the passivation layers of the metallization structure 20. The dielectric layer 108 may be formed of silicon oxide, for example by a TEOS process and be formed and be formed along with one of the passivation layers of the metallization structure 20.

The cavity 240 formed in the substrate 27 comprises a plurality of trenches 241 formed in the front surface 28 of the semiconductor substrate 27. The trenches 241 are coupled by a connecting cavity 242 formed on the front surface 28 that is covered and sealed by the dielectric layer 108. Also illustrated in figure 4, are provide portions 243 of the cavity 240 which extending vertically from the connection portion 242. The portions 243 may be provided by openings formed in a sublayer of the dielectric layer 108 through which the trenches 242 and connecting portion 241 were emptied before these openings were then sealed by the deposition of a further dielectric sublayer onto the opening to seal and create the enclosed cavity or void 240.

The semiconductor device 100 further comprises a passive component 105 which is arranged on the front surface 28 above the cavity 140. The passive component 105 may comprise an inductor, a planar inductor a resistor or a capacitor, for example. The cavity 240 is arranged between the passive component 105 and the substrate 27 and can assist in reducing eddy current and, for example, for an inductor provides improved inductor quality factor. An array of voids may also be integrated between passive component 105 and the substrate 27 to further improve the effect.

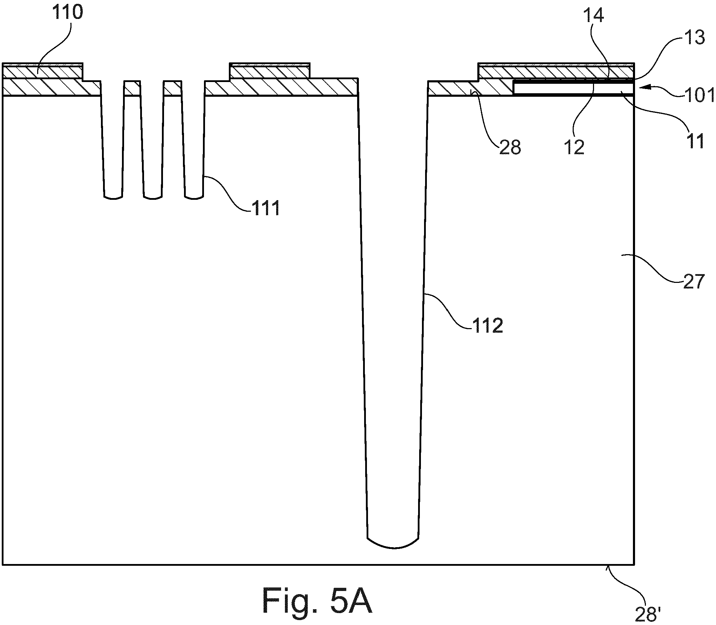

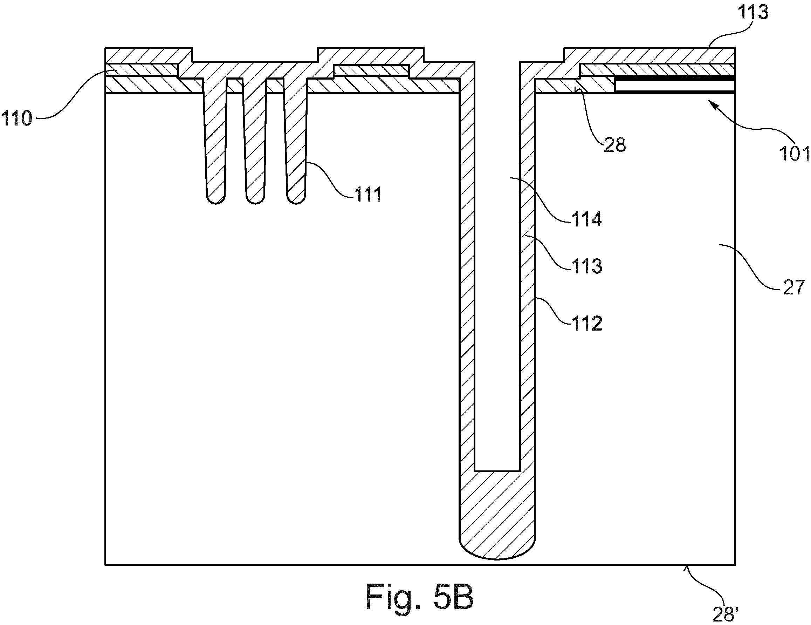

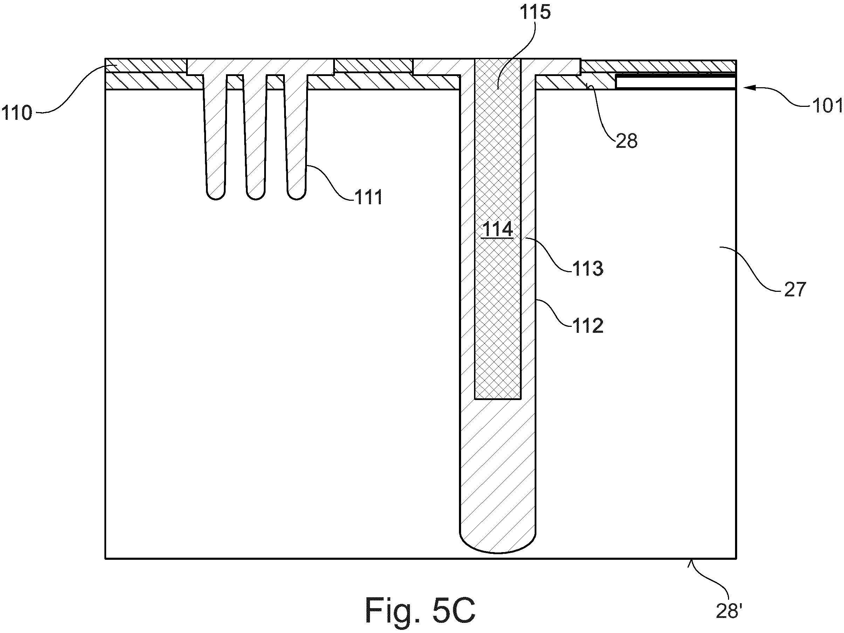

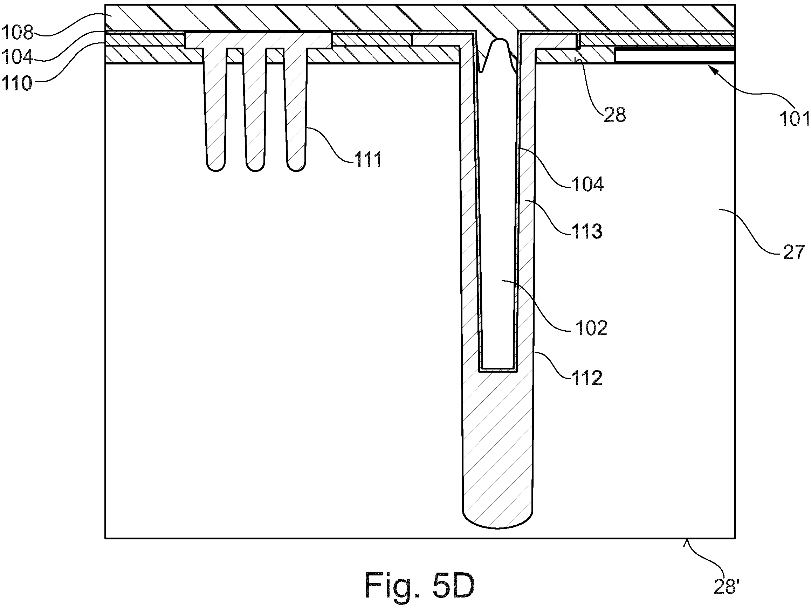

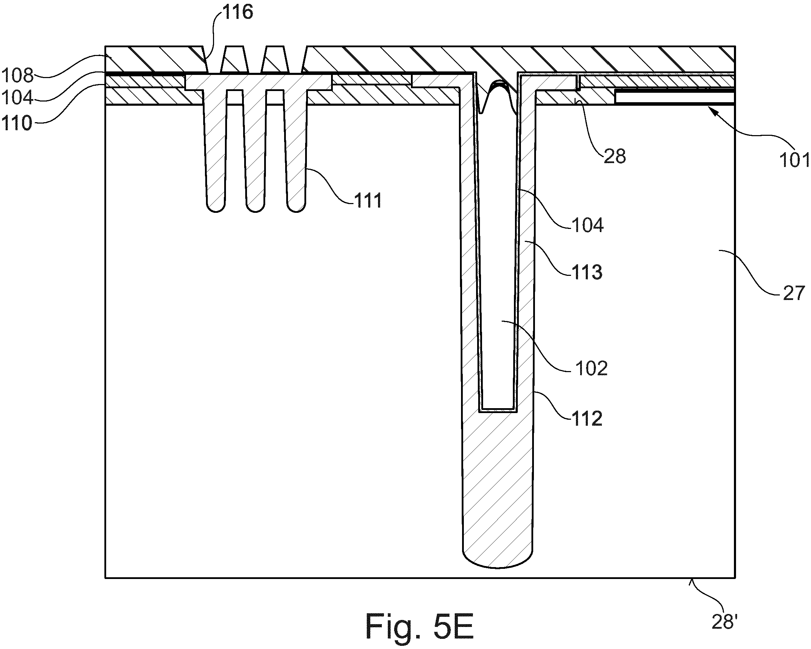

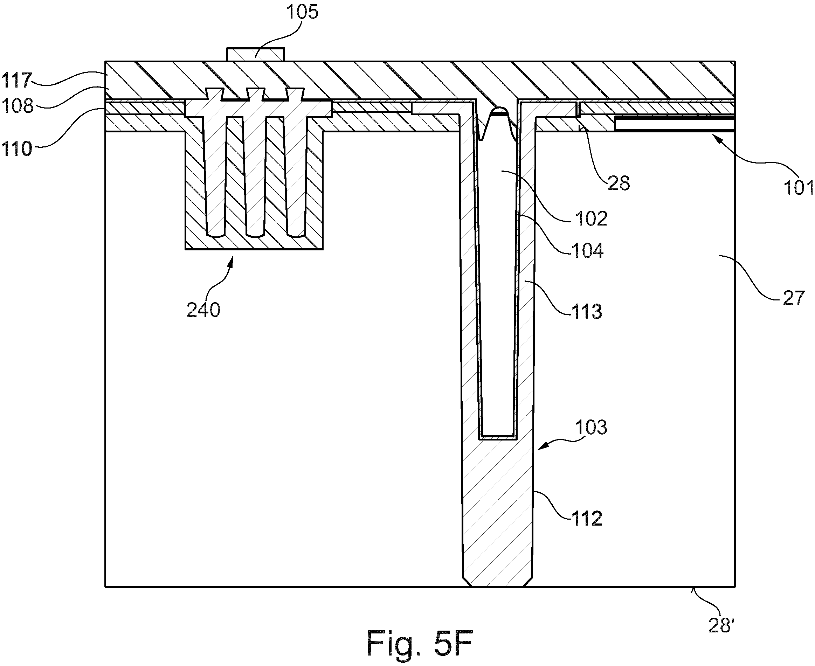

Figure 5, which includes figures 5A to 5F, illustrates a method for fabricating a cavity in a semiconductor substrate and a cavity in a through substrate via that may be used to fabricate one or both of the cavity 140 in the semiconductor substrate 27 and the cavity 102 in the through substrate via 103 of the Group III nitride-based device 100 illustrated in figure 4.

Referring to figure 5A, a substrate 27 having a front surface 28 and a rear surface 28' opposing the front surface 28 is provided. A Group III nitride-based layer 11 is arranged on the front surface 28 and comprises a Group III nitride-based transistor device 101. An insulating layer 110 is arranged on the front surface 28 of the substrate 27. The insulating layer 110 may include two sublayers, a lower sublayer that is arranged on the front surface 28 and an upper sublayer that covers the Group III nitride-based device transistor 101 and which is arranged only in regions adjacent predetermined areas in which a through substrate via and a cavity are to be formed.

At least one first blind via 111 is formed in the front surface 28 of the semiconductor substrate 27, for example by etching and at least one second blind via 112 is formed in the front surface 28 of the semiconductor substrate 27 while forming the first blind via 111. The second blind via 112 has a greater depth than the first blind via 111. The second blind via 112 is used to from the through substrate via 103 and the first blind via is used to form a cavity 240 in the substrate 27.

The first and second blind vias 111, 112 may be formed using a single etching process. A cross-sectional area of the first blind via 111 with respect to a cross-sectional area of the second blind via 112 is selected such that the etching parameters of the etching process result in a depth di of the first blind via 111 and depth d₂ of the second blind via 112 such that d₂ > di. For example, d₂ may be 60 µm and di may be 15 µm.

Referring to figure 5B, a conductive material 113 is applied to the front surface 28. The first blind vias 111 are filled with the conductive material 113 and the second blind via 112 is lined with the conductive material 112 such that the conductive material 113 forms a layer on the sidewalls and base of the second blind via 112 and surrounds a gap 114 in the second blind via 112. The conductive material 113 also extends over the front surface 28 of the substrate 27. The conductive material may be copper.

In some embodiments, the conductive material 113 has a multilayer structure and includes one or more barrier sublayers that are deposited first, for example Ti, TiN and/or W, followed by a conductive sub layer, for example formed of copper.

In some embodiments, the thickness of the conductive material 113 at the base of the second blind via 112 is greater than that on the side walls so that the base of second blind via 112 includes a plug of conductive material. This structure may be formed using a two stage process. In the first stage the conductive material 113 is deposited on and fills the lower portion of the second blind via 112 to form the plug and in the second stage lines the sidewalls and upper surface of the plug. The two stages may be performed by suitable adjustment of the deposition parameters so that in the first stage vertical growth and in the second stage horizontal growth of the conductive material 113 is favoured.

Referring to figure 5C, the second blind via 112 is filled with a sacrificial material, for example photoresist, and a planarization process carried out. Conductive material 113 may be removed from the front surface 28 completely in some regions and remain on the front surface 28 in regions immediately adjacent to the first and second blind vias 111, 112. Then the sacrificial material is removed from the second blind via 112 such that the gap 114 is formed between the conductive lining on the sidewalls and base of the second blind via 112 is open at the front surface 28. The conductive material 113 arranged in the second blind via 112 is electrically connected to the source of the Group III nitride transistor device 101, for example by way of the metallization structure 20 on the front surface 28.

Referring to figure 5D, a passivation layer 104, for example silicon nitride, is formed on the front surface 28 which covers the conductive material 113 in the vias 103 and on the front surface 28. A dielectric layer 108, for example silicon oxide, is then deposited which seals the gap 114 in the second blind via 112 to from a via cavity 102 in the second blind via 112. In this embodiment, the via cavity 102 is entirely surrounded and sealed by electrically insulating material, i.e. the layers 104 and 108.

Referring to figure 5E, at least one first opening 116 is formed in the layers 104, 108 above the first blind via 111 so as to expose a region of the conductive material 113 at the base of the first opening 116. The opening 116 may be arranged directly above or near to one of the first blind vias 111. The conductive material 113 is removed from the first blind via 111 or vias through the first opening 116, for example by wet etching and/or plasma etching. The first opening 116 may be formed by applying a mask to the dielectric layer 108. The mask may be a hard mask, for example formed of a nitride such as silicon nitride, or a soft mask formed of a photoresist.

In some embodiments, a plurality of blind vias 111 is formed filled with conductive material 113. The conductive material 113 on the front surface 28 also extends between the blind vias 111 after the planarization process. After the layers 104, 108 are applied and the conductive material 113 removed by way of the first opening 116 from the plurality of first blind vias 111 and from the front surface 28, a cavity 240 is formed in the substrate 27 which comprises a plurality of trenches or blind vias 112 connected by a connection portion 118 which are all devoid of the conductive material. In some embodiments, such as that illustrated in figure 5A, the cavity 140 is defined by material of the semiconductor substrate 27 and the second insulating layer 117.

Referring to figures 5A and 5F, a second insulating layer 117, for example silicon oxide, is applied to dielectric layer 108 to close and seal the first opening 116 and form an enclosed cavity 240.

The rear surface 28' may then be round to reveal the conductive material 113 so that a conductive connection from the front surface 28 to the rear surface 28' and the through substrate via 103is formed. A conductive layer may then be formed on the rear surface 28' which is connected to the through substrate via 103 and the source of the Group III nitride-based transistor 101 on the opposing front surface 28.

In some embodiments, a passive component 105 such as an inductor and/or a resistor is arranged on the upper surface of the semiconductor device 100 above the cavity 240 formed in the substrate 27. In some embodiments, the passive component is integrated into the metallization structure 20 formed on the front surface 28.

Figure 5F illustrates an alternative arrangement for the cavity 240, in which the first blind vias 111 are lined with an electrically insulating material, for example silicon oxide. In some embodiments, the electrically insulating lining comprises two or more sublayers which may have different compositions, for example silicon nitride and silicon oxide. In this embodiment, the cavity 240 includes three trenches or blind vias 111 each lined with the insulating material that are connected by a connection portion located on the front surface 28 that is also bounded and defined by electrically insulating material. In this embodiment, the void or cavity 240 is entirely surrounded and sealed by electrically insulating material.

The invention also provides the following examples.
Example 1. A semiconductor device, comprising:
   a substrate having a front surface,
   a Group III nitride-based layer arranged on the front surface and comprising a Group III nitride-based transistor device,
   a cavity arranged in a region of substrate,
      and/or
   a via cavity arranged in a through substrate via.
Example 2. The semiconductor device of example 1, further comprising a passive component arranged above the cavity.
Example 3. The semiconductor device of example 2, wherein the passive component comprises an inductor, a planar inductor a resistor or a capacitor.
Example 4. The semiconductor device of any one of examples 1 to 3, wherein the cavity comprises a plurality of trenches formed in the semiconductor substrate coupled by a connecting cavity formed on the front surface.
Example 5. The semiconductor device of any one of examples 1 to 4, wherein the through substrate via is coupled to the source of the Group III nitride transistor device and to a conductive layer arranged on a rear surface of the substrate.
Example 6. The semiconductor device of example 5, wherein the through substrate via comprises a first conductive portion adjacent the rear surface that fills the via and a second conductive portion on the first conductive portion that lines side faces of the via and surrounds a gap that is sealed by one or more dielectric layers to form the via cavity.
Example 7. A method, comprising:
   forming a first blind via in a front surface of a semiconductor substrate, wherein a Group III nitride-based layer is arranged on the front surface and comprises a Group III nitride-based transistor device
   applying a conductive material to the front surface and filling the first blind via with a conductive material;
   forming a first insulating layer on the front surface;
   forming a first opening in the first insulating layer so as to expose a region of the conductive material within the first opening;
   removing the conductive material from the first blind via through the first opening; and
   applying a second insulating layer to the first insulating layer to close and seal the first opening and form an enclosed cavity defined by material of the semiconductor substrate and the second insulating layer.
Example 8. The method of example 7, further comprising:
   while forming the first blind via forming at least one further first blind vias to provide a plurality of first blind vias,
   filling the plurality of first blind vias with the conductive material and applying the conductive material to the front surface,
   forming the first insulating layer over the conductive material on the front surface, and
   after removal of the conductive material through the first opening, forming a cavity comprising a plurality of trenches connected by a connection portion.
Example 9. The method of example 7 or example 8, further comprising forming a second blind via in the semiconductor substrate while forming the first blind via, the second blind via having a greater depth than the first blind via.
Example 10. The method of one of examples 7 to 9, wherein the first blind via and the second blind via are formed by etching.
Example 11. The method of example 10, wherein a cross-sectional area of the first blind via with respect to a cross-sectional area of the second blind via is selected such that first etching parameters result in a depth di of the first blind via and depth d₂ of the second blind via such that d₂ > di.
Example 12. The method of one of examples 8 to 11, wherein applying the conductive material to the front surface further comprises lining the second blind via with the conductive material such that the conductive material surrounds a gap in the second blind via and the forming the first insulating material on the front surface further comprises covering the second blind via and sealing the gap to from a via cavity in the second blind via.
Example 13. The method according to one of examples 8 to 12, further comprising after applying eh conductive material to the front surface, filling the gap in the second blind via with sacrificial material, carrying out a planarization process and removing the sacrificial material from the second blind via.
Example14. The method of any one of examples 7 to 13, further comprising arranging at least one of an inductor and a resistor on the cavity.
Example 15. A method of fabricating a Group III nitride-based transistor, comprising:
   providing a substrate comprising a Group III nitride-based layer, a first passivation layer on the first major surface of the Group III nitride-based layer and a first insulating layer arranged on the first passivation layer, the first insulating layer having a different composition from the first passivation layer;
   forming a first mask layer on the first insulating layer, the first mask layer comprising a first sublayer arranged on the first and a first photoresist sublayer on the first sublayer;
   forming a first opening for a gate electrode in the first mask layer, the first opening extending through the first photoresist sublayer and through the first sublayer;
   forming a second opening for a field plate in the first mask layer, the second opening extending through the first photoresist sublayer and through the first sublayer;
   forming a third opening for a cavity in the first mask layer, the third opening extending through the first photoresist sublayer and through the first sublayer;
   removing the first insulating layer exposed by the first opening and forming a first via for the gate electrode, the first via having a base formed by the first passivation layer;
   removing the first insulating layer exposed by the second opening and forming a second via for a field plate, the second via having a base formed by the first passivation layer;
   removing the first insulating layer exposed by the third opening and forming a third via for a cavity, the third via having a base formed by the first passivation layer;
   removing the first photoresist layer;
   applying a second photoresist layer onto the first insulating layer that covers the second opening for the field plate and the third opening for the cavity and leaves the first opening for the gate electrode and a region of the first insulating layer adjacent the first opening uncovered;
   removing the first passivation layer exposed by first via and increasing the depth of the first via such that the first via has a base formed by the Group III nitride multi-layer structure;
   removing the second resist layer;
   depositing an electrically conductive layer into the first via, the second via and the third via;
   covering the first via and the second via and removing the conductive layer from the third via;
   applying a second passivation layer onto the first insulating layer, the first via and the second via that covers and seals the third via to form a cavity.
Example 16. A method according to example 15, wherein the second resist layer leaves a portion of the first insulating layer that is arranged adjacent the first via exposed.
Example 17. A method according to example 15 or example 16, wherein the base of the first via has a width of between 50 nm and 400 nm and/or a minimum distance between the base of the first via and the second via is between 50 nm and 400 nm.
Example 18. A method according to one of examples 15 to 7, wherein the first passivation layer comprises silicon nitride, the first insulating layer comprises silicon oxide and the first sublayer comprises titanium nitride.
Example 19. A method according to one of examples 15 to 18, wherein the substrate further comprises a first ohmic contact and a second ohmic contact on the first major surface of the Group III nitride-based layer, the first passivation layer is located on the first major surface of the Group III nitride-based layer and extends between the first ohmic contact and the second ohmic contact and the first insulating layer is arranged on the first passivation layer and on the first ohmic contact and on the second ohmic contact.
Example 20. A method according to example 19, wherein the substrate comprises the first passivation layer arranged on the first major surface and the method further comprises:
   forming the first ohmic contact and the second ohmic contact on the first major surface of the Group III nitride-based layer such that the first ohmic contact and the second ohmic contact extend at least partially through the first passivation layer,
   covering the first ohmic contact and the second ohmic contact with a first sublayer of passivation material,
   planarising to form an intermediate planarized surface comprising a surface of the first ohmic contact, a surface of the second ohmic contact and the first sublayer,
   forming a second sublayer of passivation material on the planarized surface and arranged on the first ohmic contact and the second ohmic contact, the first and second sublayers forming the first insulating layer.
Example 21. A method according to example 19 or example 10, further comprising:
   forming a fourth opening in the first sublayer, the fourth opening extending through the first photoresist layer and the first sublayer and being positioned above the second ohmic contact;
   removing the first insulating layer exposed in the fourth opening and forming a fourth via having a base exposing a portion of the second ohmic contact;
   covering the fourth via with the second resist layer, and
   after removal of the second resist layer further depositing the electrically conductive material into the fourth via,
   planarising to form a planarised surface comprising isolated areas of electrically conductive material positioned in the first, second, third vias and fourth, each isolated area of electrically conductive material being surrounded by the first insulating layer.
Example 22. A method according to example 21, further comprising:
   forming a second passivation layer on the first insulating layer and on the isolated areas of electrically conductive material;
   forming a second insulating layer on the second passivation layer, the second passivation layer and second insulation layers having differing compositions;
   structuring the second insulation layer to form a first trench positioned above the first via, the first trench having a base spaced apart from the first via by a portion of the second insulating layer and the second passivation layer, the first trench being laterally wider than the first via;
   forming a fifth via in the base of the first trench that exposes the electrically conductive material in the first via by removing the second insulation layer and the second passivation layer, the fifth via being laterally smaller than the first trench;
   forming a second electrically conductive material layer in the fifth via and in the first trench.
Example 23. A method according to example 22, further comprising:
   structuring the second insulation layer to form a second trench above the second via and a third trench above the fourth via, the second trench having a base spaced apart from the second via by a portion of the second insulating layer and the second passivation layer, the second trench being laterally wider than the second via, the third trench having a base spaced apart from the fourth via by a portion of the second insulating layer and the second passivation layer, the third trench being laterally wider than the third via;
   forming a sixth via in the second trench that exposes the electrically conductive material in the second via by removing the second insulation layer in the base of the second trench;
   forming a seventh via in the third trench that exposes the electrically conductive material in the fourth via by removing the second insulation layer in the base of the third trench;
   depositing the second electrically conductive material layer into the second and third trenches and into the sixth and seventh vias.
Example 24. A method according to any one of examples 15 to 23, wherein the electrically conductive material is tungsten.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Group III nitride-based semiconductor device, comprising:
a multilayer Group III nitride-based structure comprising a first major surface;
a source electrode, a gate electrode and a drain electrode arranged on the first major surface, wherein the gate electrode is laterally arranged between the source electrode and the drain electrode;
a metallization structure arranged on the first major surface and comprising an electrically insulating layer arranged on the source electrode, the gate electrode and the drain electrode and a conductive redistribution structure electrically connected to the source electrode, the gate electrode and the drain electrode;
wherein one or more cavities are located in the electrically insulating layer.

2. A Group III nitride-based semiconductor device according to claim 1, wherein the cavity is filled with a gas or a vacuum and has a dielectric constant that is lower than that of the dielectric constant of the electrically insulating layer.

3. A Group III nitride-based semiconductor device according to claim 1 or claim 2, wherein the cavity is arranged laterally between the source electrode and the gate electrode and/or laterally between the gate electrode and the drain electrode and/or is positioned above the gate electrode and/or has an elongate form having a length that extends substantially parallel to the gate electrode.

4. A Group III nitride-based semiconductor device according to one of claims 1 to 3, further comprising a field plate that is arranged on the first major surface between the gate electrode and the drain electrode, and the cavity is arranged laterally between the field plate and the drain electrode and/or is positioned above the field plate.

5. A Group III nitride-based semiconductor device according to one of claims 1 to 4, wherein at least two discrete cavities are arranged in the metallization structure in a stacked arrangement.

6. A Group III nitride-based semiconductor device according to claim 4, wherein the metallization structure comprises a lateral gate redistribution structure that is electrically connected to the gate electrode by one or more gate vias and a lateral field plate redistribution structure that is electrically connected to the field plate by one or more field plate vias.

7. A Group III nitride-based semiconductor device according to claim 6, wherein the cavity is arranged vertically between the gate electrode and the lateral gate redistribution structure and/or vertically between the field plate and the lateral field plate redistribution structure.

8. A Group III nitride-based semiconductor device according claim 6 or claim 7, wherein the lateral field plate redistribution structure extends over and is vertically spaced apart from the gate electrode.

9. A Group III nitride-based semiconductor device according to one of claims 6 to 8, wherein the source electrode is electrically coupled to the lateral field plate redistribution structure by one or more source conductive vias.

10. A Group III nitride-based semiconductor device according to one of claims 6 to 9, wherein the source electrode, the gate electrode, the drain electrode and the field plate are elongate and each have a longest dimension that extends in a longitudinal direction
wherein the lateral field plate redistribution structure comprises a plurality of transverse sections spaced at intervals in the longitudinal direction, each transverse section extending over and being vertically spaced apart from the gate electrode and being electrically coupled to the field plate by one of the field plate conductive vias.

11. A Group III nitride-based semiconductor device according to claim 10, wherein the lateral field plate redistribution structure further comprises a longitudinal section positioned above the field plate and extending substantially parallel to the longitudinal direction and to the field plate, wherein the longitudinal section is connected to the transverse sections.

12. A Group III nitride-based semiconductor device according to claim 10 or claim 11, wherein the lateral gate distribution structure comprises a plurality of transverse sections spaced at intervals in the longitudinal direction, each transverse section being vertically spaced apart from the gate electrode and electrically coupled to the gate electrode by one of the gate conductive vias, wherein the transverse sections of the lateral gate redistribution structure are interleaved with the transverse sections of the lateral field plate distribution structure.

13. A Group III nitride-based semiconductor device according to claim 14, wherein the transverse sections of the lateral gate redistribution structure extend over and are vertically spaced apart from the source electrode and are electrically connected to a gate runner that is positioned on an opposing side of the source electrode from the gate electrode.

14. A Group III nitride-based semiconductor device according to one of claims 1 to 13, wherein the multilayer Group III nitride-based structure comprises a Group III nitride channel layer and a Group III nitride barrier layer arranged on the Group III nitride channel layer and forming a heterojunction therebetween capable of supporting a two-dimensional charge gas, wherein the source electrode, the gate electrode and the drain electrode are arranged on or in the Group III nitride barrier layer.

15. A Group III nitride-based semiconductor device according to one of claims 1 to 14, wherein the metallization structure further comprises an upper electrically insulating layer and an upper conductive redistribution structure and at least one cavity is arranged in the upper electrically insulating layer.
